# DEMANDE DE BREVET EUROPEEN

(11) **EP 4 770 312 A1**
(43) Date de publication de la demande: **01.07.2026**
(21) Numéro de dépôt: 25227031.9
(22) Date de dépôt: 23.12.2025
(51) Int. Cl.: H10B 51/30, H10D 30/47, H10D 62/10, H10D 62/80

(54) **TRANSISTOR NON-VOLATIL, ASSEMBLAGE DE TRANSISTORS NON-VOLATILS ET MATRICE DE TRANSISTORS NON-VOLATILS**

(30) Priorité: 26.12.2024 FR 2415282
(71) Demandeur: Commissariat à l'Energie Atomique et aux Energies Alternatives, 75015 Paris (FR); Université Grenoble Alpes, 38400 Saint-Martin-d'Hères (FR); Centre National de la Recherche Scientifique, 75016 Paris (FR); Institut Polytechnique de Grenoble, 38000 Grenoble (FR)
(72) Inventeur: FROTTIER, Théo, 38054 GRENOBLE CEDEX 09 (FR); CULOT, Maxime, 38054 GRENOBLE CEDEX 09 (FR); SAVERO-TORRES, Williams, 38000 GRENOBLE (FR); TERESI, Salvatore, 38054 GRENOBLE CEDEX 09 (FR); SGARRO, Paolo, 38054 GRENOBLE CEDEX 09 (FR); KANDAZOGLOU, Aurélie, 38054 GRENOBLE CEDEX 09 (FR); ATTANE, Jean-Philippe, 38054 GRENOBLE CEDEX 09 (FR); VILA, Laurent, 38054 GRENOBLE CEDEX 09 (FR); BIBES, Manuel, 38054 GRENOBLE CEDEX 09 (FR)
(74) Mandataire: Cabinet Camus Lebkiri

(57) **Abrégé**

L'invention concerne un transistor (10) non-volatil comprenant une couche semi-conductrice ferroélectrique (11) comprenant un domaine ferroélectrique (12) présentant une polarisation électrique spontanée (13) pouvant prendre une pluralité d'états distincts, une source (14), une grille (15) et un drain (16). La source (14), la grille (15) et le drain (16) sont distants les uns des autres et agencés de sorte qu'un potentiel électrique appliqué entre la source (14) et la grille (15) applique un champ électrique sur le domaine ferroélectrique (12), le drain (16) étant en contact électrique avec la couche ferroélectrique (11), la source (14) formant, avec la couche ferroélectrique (11), une barrière Schottky (17) au niveau d'une interface entre la source (14) et la couche ferroélectrique (11) présentant une résistance électrique fonction de la polarisation électrique (13), le transistor étant tel que la couche semi-conductrice ferroélectrique (11) est dégénérée au niveau de l'interface entre la source (14) et la couche ferroélectrique (11) et la couche semi-conductrice ferroélectrique (11) présente une conductivité électrique indépendante de la polarisation spontanée (13).

## Description

### DOMAINE TECHNIQUE DE L'INVENTION

Le domaine technique de l'invention est celui des dispositifs mémoires et de calcul logique et en particulier des transistors non-volatils. Il concerne également celui des assemblages et matrices formés à partir de tels transistors.

### ARRIÈRE-PLAN TECHNOLOGIQUE DE L'INVENTION

L'intérêt majeur de l'industrie de la microélectronique et des semi-conducteurs est d'augmenter continuellement les puissances de calcul ainsi que les capacités de stockage des appareils numériques. Pour ce faire, une solution employée jusqu'alors était de réduire la taille des transistors pour augmenter leur nombre sur une même surface.

Actuellement, les transistors ont atteint des tailles pour lesquels des effets quantiques entrent en jeux. Ces courants augmentent la consommation électrique globale de fonctionnement des transistors et empêchent de ce fait la réduction de leur taille.

Pour diminuer la consommation d'énergie des unités de calcul et de mémoire et permettre d'augmenter davantage leurs capacités, il est devenu nécessaire de trouver une alternative aux transistors logiques (tels que les transistors dit « CMOS », « DRAM », « SRAM », et « NAND flash ») conventionnels grâce à l'emploi de nouveaux phénomènes physiques.

Une architecture de circuits électroniques utilisée depuis quelques décennies est appelée « architecture de von Neumann ». Elle sépare physiquement les espaces de stockage d'information tels que les mémoires non-volatiles et volatiles (aussi appelées « RAM » pour « Random Access Memory » en anglais) et les unités de calcul (dites également « CPU » pour « Central Processing Unit » en anglais). Cette séparation physique peut atteindre plusieurs centimètres dans un ordinateur. L'information stockée dans la mémoire doit alors être transférée jusqu'à l'unité de calcul et un résultat du calcul doit être transféré en retour vers la mémoire. Ces transferts consomment à la fois du temps et de l'énergie.

Pour diminuer la consommation d'énergie des architectures de circuit électronique et augmenter leurs performances, il est devenu nécessaire de trouver une alternative à l'architecture de von Neumman.

De nouvelles architectures sont proposées pour, par exemple, réaliser des calculs directement dans la mémoire, dit « in-memory computing » en anglais, ou réaliser des calculs selon un schéma proche du cerveau humain, aussi appelé « calcul neuromorphique » ou « neuromorphic computing » en anglais. Pour pouvoir mettre en place ces nouvelles architectures, il est nécessaire d'employer de nouveaux dispositifs. Ces derniers doivent, entre autres, stocker une information de façon non-volatile, consommer peu d'énergie, être endurants et être rapides.

Un nouveau type de dispositifs à deux terminaux, appelés « memristors » (ou « memristances »), regroupe les composants électroniques passifs pouvant modifier leurs résistances électriques de manière non-volatile (aussi dit « permanente ») grâce à l'application de courants ou de tensions. Une information non-volatile peut alors être stockée dans ces dispositifs et lue via une lecture classique de résistance.

Ces memristors peuvent, dans un premier temps, être utilisés en tant que mémoire de masse ou en tant que mémoire vive grâce à leur non-volatilité.

Ils peuvent aussi être assemblés pour former les mêmes fonctions logiques que les transistors CMOS (ou « Complementary Metal Oxide Semiconductor » en anglais) et ainsi être utilisés pour du calcul. Étant non-volatils, il n'est alors plus nécessaire d'utiliser l'architecture von Neumann, l'information étant déjà stockée dans les éléments de calculs. On parle alors de calcul dans la mémoire.

Ils peuvent aussi être assemblés pour former des matrices performant l'opération de multiplication et d'addition (« multiply accumulate » ou « MAC » en anglais). Ce type d'opération est utile notamment pour le calcul neuromorphique.

Parmi les memristors les plus connus on retrouve les mémoires dites « PCRAM » pour « Phase Change Random Access Memory » en anglais, pour lesquelles l'information est stockée au moyen de la phase cristalline ou amorphe d'un matériau à changement de phase ou encore les mémoires dites « ReRAM » pour « Resistive Random Access Memory » en anglais, pour lesquelles l'information est stockée au moyen du déplacement de lacunes (par exemple de lacunes d'oxygène) ou d'ions métalliques dans un matériau. Ces memristors montrent de grands rapports « ON/OFF » de résistance mais possèdent des problèmes d'endurance et de fiabilité. Le rapport « ON/OFF » d'un dispositif correspond au rapport de la résistance du dispositif la plus élevée par la résistance du dispositif la plus faible.

On retrouve aussi les mémoires dites « MRAM » pour « Magnetoresistive Random Access Memory » en anglais, pour lesquelles l'information est stockée au moyen de la direction d'aimantation d'un matériau ferromagnétique. Ces memristors montrent de bonnes caractéristiques d'endurance et de fiabilité mais possèdent de faibles rapports ON/OFF de résistance.

Il existe aussi les mémoires « FRAM » pour « Ferroelectric Random Access Memory » en anglais, pour lesquelles l'information est stockée au moyen de la polarisation électrique d'un matériau ferroélectrique. Ces mémoires présentent de bonnes caractéristiques d'endurance et de fiabilité ainsi que de forts rapports ON/OFF mais dont la lecture est destructive.

De plus, ces mémoires à deux terminaux doivent nécessairement utiliser le même chemin pour l'écriture et la lecture de l'information.

Modifier l'information contenue dans un paramètre d'ordre (par exemple un arrangement cristallin d'une couche active) peut nécessiter des contraintes physiques différentes que celles souhaitées le long d'un chemin de lecture. Pour optimiser l'écriture et la lecture d'un memristor, séparer les chemins de lecture et d'écriture peut s'avérer avantageux.

Il existe donc un besoin de fournir un dispositif memristor présentant de bonnes caractéristiques d'endurance et de fiabilité, un grand rapport ON/OFF de résistances, dont la lecture n'est pas destructive et dont les chemins de lecture et d'écriture sont différents. Ce dispositif peut être décrit comme une transistor.

Similaires au besoin, des transistors exploitant la ferroélectricité ont été proposés. Le transistor à effet de champ ferroélectrique, dit également « Fe-FET » pour « Ferroelectric Field Effect Transistor » en anglais, est basé sur le même principe que le transistor à effet de champ classique, en ajoutant un élément ferroélectrique pour introduire la non-volatilité. Pour rappel, un transistor à effet de champ, dit « FET » pour « Field Effect Transistor » en anglais, comprend une couche semi-conductrice, dite « canal », reliant deux électrodes conductrices dites « source » et « drain ». Une troisième électrode conductrice, dite « grille », séparée du canal par un isolant, permet d'appliquer un champ électrique sur le canal pour moduler sa conduction. Dans un transistor Fe-FET, le champ électrique appliqué sur le canal est généré par une couche en matériau ferroélectrique qui est disposée au voisinage du canal. Cette couche maintient ainsi le champ électrique sur le canal même lorsqu'il n'est pas alimenté en énergie. De plus, l'information n'a pas besoin d'être rafraîchie de manière périodique. De ce fait le Fe-FET consomme peu d'énergie en régime statique. De plus, la lecture de l'état stocké dans la couche ferroélectrique peut être réalisée de manière non destructive.

La couche ferroélectrique d'un Fe-FET est toutefois difficile à intégrer dans l'industrie des semi-conducteurs actuelle car elle est réalisée à partir d'oxyde pérovskite. L'emploi de matériau compatible avec l'industrie des semi-conducteurs actuelle, par exemple à base d'hafnium, ne montre toutefois pas de résultats suffisants en termes d'endurance ou de vieillissement.

On connait également un transistor FET à semi-conducteur ferroélectrique, dit également « FeS-FET » pour « Ferroelectric Semiconductor FET » en anglais, qui comprend un canal semi-conducteur ferroélectrique dans lequel l'information est stockée. Le document [Si & al. « A Ferroelectric Semiconductor Field-Effect Transistor », Nat Electron 2, 580-586 (2019) https://doi.org/10.1038/s41928-019-0338-7] divulgue un exemple de transistor FeS-FET à semi-conducteur ferroélectrique. Dans cet exemple, le transistor comprend une couche semi-conductrice ferroélectrique et trois électrodes conductrices agencées de manière à former une source et un drain en contact avec la couche semi-conductrice ferroélectrique, et une grille, isolée de la couche semi-conductrice ferroélectrique. La polarisation électrique de la couche semi-conductrice ferroélectrique peut influencer les bandes de conduction et de valence de la couche semi-conductrice ferroélectrique de manière à créer, pour un état de polarisation, une surface conductrice entre la source et le drain. Le transistor est dans un état passant. Pour un autre état de polarisation, la surface conductrice est absente et le transistor est bloquant.

Pour obtenir ce comportement, il est toutefois nécessaire que le canal semi-conducteur ferroélectrique soit non dégénéré et donc soit un mauvais conducteur (le niveau de Fermi doit se situer dans la bande interdite du canal) ce qui limite les applications d'un tel transistor. La polarisation du matériau ferroélectrique doit également être renversée sur tout le canal, bien que la différence de potentiel pour son contrôle ne soit appliquée qu'entre la source et la grille. En effet, la surface conductrice doit s'étendre entre la source et le drain pour réaliser la conduction. Une zone de la couche semi-conductrice ferroélectrique non polarisée correctement peut couper la surface conductrice. Il en résulte que le contrôle de l'état ferroélectrique du canal peut être difficilement contrôlable, avec une grande variabilité d'un dispositif à l'autre.

Le Fe-FET et le FeS-FET modulent tous deux la conductivité du canal en fonction d'un état ferroélectrique. Cette modulation restreint la géométrie du transistor à un dispositif à trois terminaux et ainsi les possibilités d'assemblage pour former différentes fonctions logiques.

Il existe donc un besoin de fournir un transistor ou un memristor non-volatil présentant de bonnes caractéristiques d'endurance et de fiabilité, un grand rapport ON/OFF de résistances, dont la lecture n'est pas destructive, dont les chemins de lecture et d'écriture sont différents et dont la conductivité du canal ne dépend pas de l'information encodée.

### RÉSUMÉ DE L'INVENTION

L'invention offre une solution aux problèmes précités en scindant des chemins de courant de charge pour réaliser une écriture et une lecture de l'état stocké dans un transistor.

Pour cela, l'invention concerne un transistor non-volatil comprenant :
- une couche semi-conductrice ferroélectrique comprenant au moins un domaine ferroélectrique, le domaine ferroélectrique présentant une polarisation électrique spontanée pouvant prendre une pluralité d'états distincts ;
- une première électrode conductrice, formant une « source » ;
- une deuxième électrode conductrice, formant une « grille » ; et
- une troisième électrode conductrice, formant un « drain »,

la source, la grille et le drain étant distants les uns des autres et agencés de sorte qu'un potentiel électrique appliqué entre la source et la grille applique un champ électrique sur le domaine ferroélectrique, le drain étant en contact électrique avec la couche semi-conductrice ferroélectrique, la source formant, avec la couche semi-conductrice ferroélectrique, une barrière Schottky au niveau d'une interface entre la source et la couche semi-conductrice ferroélectrique, la barrière Schottky présentant une résistance électrique fonction de la polarisation électrique, ledit transistor étant tel que :
- la couche semi-conductrice ferroélectrique est dégénérée au moins au niveau de l'interface entre la source et la couche semi-conductrice ferroélectrique ; et
- la couche semi-conductrice ferroélectrique présente une conductivité électrique indépendante de la polarisation électrique spontanée.

Par « ferroélectrique », on entend un matériau ou un objet (par exemple un domaine) porteur d'une configuration de moments diélectriques et susceptible de présenter une configuration des moments diélectriques (par exemple un alignement de ces moments diélectriques) formant un moment diélectrique macroscopique dit également « polarisation électrique spontanée ».

Par « polarisation électrique spontanée », on entend également « polarisation ferroélectrique », « polarisation électrique » ou plus simplement « polarisation ». Par « état de polarisation », on entend une configuration particulière et stables des moments diélectriques formant la polarisation électrique spontanée. Il s'agit par exemple d'une orientation que peuvent prendre les moments diélectriques.

Par « domaine ferroélectrique », on entend une zone de la couche ferroélectrique comprenant des moments dipolaires dont l'orientation est uniforme.

Par « contact électrique », on entend un contact entre deux éléments permettant le passage d'un courant de charges électriques lorsque certaines conditions sont remplies. Il s'agit par exemple d'un contact direct (par exemple formant, au moins sous certaines conditions, un contact ohmique) ou un contact réalisé par l'intermédiaire d'une fine couche (formant par exemple une barrière de diffusion, une couche protectrice, une couche favorisant un certain type de croissance ou une couche isolante permettant le passage d'un courant par effet tunnel).

Par « barrière Schottky », on entend une barrière d'énergie potentielle pour les charges électriques formée à une jonction métal - semi-conducteur.

Par « non-volatil », on entend que les états de la polarisation électrique sont stables. La polarisation conserve ainsi son état pendant une durée suffisamment longue pour l'application visée. Elle est par exemple supérieure ou égale à quelques microsecondes aux températures de fonctionnement visées, et avantageusement bien supérieure à une seconde. La polarisation électrique permet ainsi de stocker une information de manière non-volatile. L'application d'un potentiel entre la source et la grille permet d'appliquer un champ électrique sur la polarisation électrique pour commuter cette dernière dans un de ses différents états de polarisation. L'application d'un potentiel entre la source et la grille permet donc d'écrire un état dans le transistor. Puisque seul un champ électrique est nécessaire pour commuter la polarisation, il n'est pas nécessaire que la conduction électrique entre la source et le drain soit élevée. Autrement dit, le chemin employé pour réaliser une écriture pour le transistor (dit « chemin d'écriture ») peut présenter une résistance aussi élevée que nécessaire. Le chemin d'écriture peut donc être dimensionné et les matériaux choisis de telle sorte que le courant électrique circulant dans le transistor lors de l'écriture soit faible, voire nul.

Par « dégénéré », on entend un matériau dont le niveau de Fermi ne se situe pas dans la bande interdite de la couche ferroélectrique ou un matériau dont le niveau de Fermi se situe dans la bande interdite de la couche ferroélectrique mais à proximité de la bande de valence ou à proximité de la bande de conduction ». Par « à proximité d'une bande », on entend à moins de 50 meV de ladite bande. Autrement dit, le niveau de Fermi peut être au maximum à 50 meV au-dessus de la bande de valence ou au minimum à 50 meV en-dessous de la bande de conduction. De la sorte, le matériau est conducteur à température ambiante (par exemple à 300 K).

Par « dégénéré au moins au niveau de l'interface », on entend que la couche ferroélectrique est dégénérée localement, le reste de la couche ferroélectrique restant non dégénéré. La dégénération locale est par exemple obtenue par un dopage locale de la couche ferroélectrique.

La lecture de l'état de la polarisation de la couche semi-conductrice ferroélectrique peut être réalisée en mesurant la résistance de la barrière Schottky formée entre la couche semi-conductrice ferroélectrique et la source. On peut par exemple exploiter le chemin dit « de lecture » entre la source et le drain pour mesurer la résistance de la barrière Schottky.

Ainsi, employer un chemin d'écriture (entre la source et la grille) et un chemin de lecture (entre la source et le drain) différents, permet d'offrir un transistor dont le risque de détruire l'information lors de la lecture est réduit, tout en présentant de bonnes performances.

Il peut arriver que la couche ferroélectrique comprenne plusieurs domaines ferroélectriques, chacun d'eux étant porteur d'une polarisation électrique différente. La polarisation influençant la barrière Schottky peut n'être attachée qu'à un seul de ces domaines ferroélectriques. Puisqu'il n'y a que cette polarisation qui permette de moduler la barrière Schottky, il n'est pas nécessaire de faire commuter les autres domaines ferroélectriques qui n'ont pas d'interaction avec la barrière Schottky. Il n'est donc pas nécessaire de faire commuter toute la couche ferroélectrique. Le seul domaine porteur de la polarisation couplée à la barrière Schottky est suffisant. Dès lors, l'énergie à appliquer pour utiliser le transistor peut être réduite. Le transistor peut donc présenter de bonnes performances en termes de commutation.

De plus, il n'y a pas de différence notable si un seul domaine commute ou si plusieurs autres domaines, n'ayant pas d'interaction avec la barrière Schottky, commutent également. Dès lors que le domaine couplé à la barrière Schottky a commuté, peu importe que d'autres domaines l'aient suivi ou non dans sa commutation. La commutation du transistor offre donc une bonne reproductibilité.

L'application d'un potentiel électrique entre la source et la grille permet ainsi de moduler la résistance de la barrière Schottky. Ainsi, la conductivité entre la source et le drain peut être contrôlée par l'application d'une tension entre la source et la grille, de la même manière qu'un transistor conventionnel. Ainsi, le transistor peut être utilisé comme un transistor conventionnel, par exemple dans une architecture de calcul.

Il est intéressant de noter que le transistor n'est pas un transistor à effet de champ (aussi appelé « FET » pour « Field Effect Transistor » en anglais). En effet, il ne comprend pas de canal à proprement parler. Dans un transistor de type FET, la conduction du canal est modulée par l'application d'un champ électrique au voisinage d'un canal. Dans le transistor selon l'invention, la conduction de la couche semi-conductrice reste inchangée. C'est uniquement la résistance d'une interface entre une électrode et la couche ferroélectrique qui est modulée. Autrement dit, la résistance ente la grille et le drain reste inchangée. Le transistor n'étant pas à effet de champs, il évite ainsi les limites physiques des transistors FET qui rendent difficiles la diminution de la taille du canal ou encore la diminution des tensions d'utilisations.

Le transistor selon l'invention n'est pas non plus comparable à un transistor FET à semi-conducteur ferroélectrique, dit également « FeS-FET ». Pour un Fes-FET, la conductivité de la couche semi-conductrice formant le canal est modulée en fonction de la polarisation électrique. Le transistor selon l'invention se distingue donc d'un FeS-FET en ce que la conductivité électrique de la couche semi-conductrice ferroélectrique ne dépend pas de la polarisation électrique et reste constante quel que soit l'état de polarisation dans lequel se trouve la polarisation électrique.

Dans un mode de réalisation, la couche semi-conductrice ferroélectrique est entièrement dégénérée. Elle présente donc une bonne conductivité électrique. Le chemin de lecture présente donc, lorsque le transistor est passant, une très faible résistance. De plus, la variation de la résistance de la barrière Schottky peut être relativement importante au regard de la résistance totale du chemin de lecture.

De plus, puisque le chemin de lecture présente une résistance faible, on peut appliquer un potentiel électrique faible pour réaliser cette lecture. Dès lors, la lecture de l'état du transistor est facilitée. La consommation électrique pour réaliser une telle lecture est donc réduite. De plus, un potentiel électrique faible a moins de chance de perturber la polarisation électrique du transistor.

Outre les caractéristiques qui viennent d'être évoquées dans les paragraphes précédents, le transistor selon l'invention peut présenter une ou plusieurs caractéristiques complémentaires parmi les suivantes, considérées individuellement ou selon toutes les combinaisons techniquement possibles :

La grille est électriquement isolée de la couche semi-conductrice ferroélectrique.

La couche semi-conductrice ferroélectrique comprend une première sous-couche semi-conductrice ferroélectrique et une deuxième sous-couche ferroélectrique, la source formant la barrière Schottky avec la première sous-couche semi-conductrice ferroélectrique, la deuxième sous-couche ferroélectrique étant disposée entre la première sous-couche semi-conductrice ferroélectrique et la grille, la deuxième sous-couche ferroélectrique présentant une conductivité électrique inférieure à la première sous-couche semi-conductrice ferroélectrique.

La grille et le drain sont agencés de sorte qu'un potentiel électrique appliqué entre la grille et le drain applique un champ électrique sur le domaine ferroélectrique.

Le drain forme, avec la couche semi-conductrice ferroélectrique, une barrière Schottky supplémentaire, au niveau d'une interface entre le drain et la couche semi-conductrice ferroélectrique, la couche semi-conductrice ferroélectrique étant également dégénérée au moins au niveau de l'interface entre le drain et la couche semi-conductrice ferroélectrique, la barrière Schottky supplémentaire présentant une résistance électrique fonction de la polarisation électrique.

La couche semi-conductrice ferroélectrique comprend un domaine ferroélectrique supplémentaire, présentant une polarisation électrique spontanée pouvant prendre une pluralité d'états distincts, le drain formant, avec la couche semi-conductrice ferroélectrique, une barrière Schottky supplémentaire, au niveau d'une interface entre le drain et la couche semi-conductrice ferroélectrique, la couche semi-conductrice ferroélectrique étant également dégénérée au moins au niveau de l'interface entre le drain et la couche semi-conductrice ferroélectrique, la barrière Schottky supplémentaire présentant une résistance électrique fonction de la polarisation électrique du domaine ferroélectrique supplémentaire.

Le drain et la grille sont agencés de sorte qu'un potentiel électrique appliqué entre le drain et la grille applique un champ électrique sur le domaine ferroélectrique supplémentaire.

Le transistor selon l'invention comprend un espaceur conducteur et non-ferroélectrique, la couche ferroélectrique étant séparée en deux portions distincts par l'espaceur, l'espaceur formant un contact ohmique avec chacune des deux portions de la couche ferroélectriques, l'une des portions de la couche ferroélectrique comprenant le domaine ferroélectrique et l'autre portion de la couche ferroélectrique comprenant le domaine ferroélectrique supplémentaire.

La grille comprend une première portion et une deuxième portion, la première portion de grille étant agencée de sorte qu'un potentiel électrique appliqué entre la source et la première portion de grille applique un champ électrique sur le domaine ferroélectrique, la deuxième portion de grille étant agencée de sorte qu'un potentiel électrique appliqué entre le drain et la deuxième portion de grille applique un champ électrique sur le domaine ferroélectrique supplémentaire.

L'invention concerne également un assemblage de transistors non-volatils comprenant une pluralité de transistors non-volatils selon l'invention pour lesquels les couches semi-conductrices ferroélectriques sont communes et forment une seule et même couche semi-conductrice ferroélectrique et pour lesquels les drains sont communs et forment un seul et même drain commun, à chaque transistor non-volatil correspond au moins un domaine ferroélectrique, le domaine ferroélectrique présentant une polarisation électrique spontanée pouvant prendre une pluralité d'états distincts.

Outre les caractéristiques qui viennent d'être évoquées dans les paragraphes précédents, l'assemblage de transistors non-volatils selon l'invention peut présenter une ou plusieurs caractéristiques complémentaires parmi les suivantes, considérées individuellement ou selon toutes les combinaisons techniquement possibles :

Les sources sont électriquement connectées les unes aux autres, voire les sources sont communes et forment une seule et même source, et les grilles sont distinctes.

Les grilles sont communes et forment une seule et même grille et dans lequel les sources sont distinctes.

L'assemblage selon l'invention comprend un nanofil et un nanotube entourant le nanofil, le nanotube formant la couche semi-conductrice ferroélectrique des transistors, le nanofil formant les grilles des transistors, le drain commun étant en contact électrique avec le nanotube.

L'invention concerne en outre une matrice de transistors non-volatils comprenant :
- une première pluralité de lignes conductrices, dites « lignes de source » ;
- une deuxième pluralité de lignes conductrices, dites « lignes de mots » ;
- une troisième pluralité de lignes conductrices, dites « lignes de données » ; et
- une pluralité de transistors non-volatils selon l'invention,
la source de chaque transistor étant connectée à l'une des lignes de source , la grille de chaque transistor étant connectée à l'une des lignes de mots et le drain de chaque transistor étant connectée à l'une des lignes de données.

Selon un mode de réalisation, les transistors de la matrice selon l'invention sont connectés à une même ligne de mots appartenant au dit au moins un assemblage.

L'invention et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif de l'invention. Sauf précision contraire, un même élément apparaissant sur des figures différentes présente une référence unique.
Les [Fig. 1] et [Fig. 2] présentent un premier mode de réalisation d'un transistor non-volatil selon l'invention dans deux configurations d'utilisation différentes.
Les [Fig. 3], [Fig. 4], [Fig. 5], [Fig. 6], [Fig. 7] et [Fig. 8] présentent six modes de réalisation supplémentaires du transistor selon l'invention.
Les [Fig. 9], [Fig. 10], [Fig. 11] et [Fig. 12] présentent trois modes de réalisation d'un assemblage de transistors non-volatils selon l'invention.
Les [Fig. 13] et [Fig. 14] présentent deux modes de réalisation d'une matrice de transistors non-volatils selon l'invention.

### DESCRIPTION DÉTAILLÉE

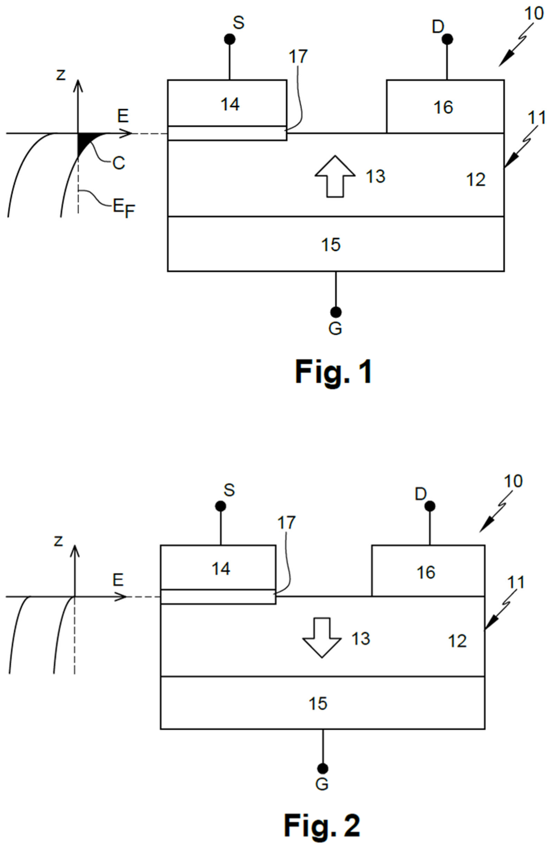

L'invention se propose d'offrir un moyen de stocker une information de manière non-volatile, qui puisse être utilisée dans une architecture de calcul. Les figures 1 à 7 présentent plusieurs modes de réalisation d'un transistor 10 selon l'invention offrant de telles propriétés.

Les figures 1 et 2 illustrent un premier mode de réalisation du transistor 10 dans deux configurations différentes ainsi qu'un diagramme de bandes {E ; z} associé à chaque configuration.

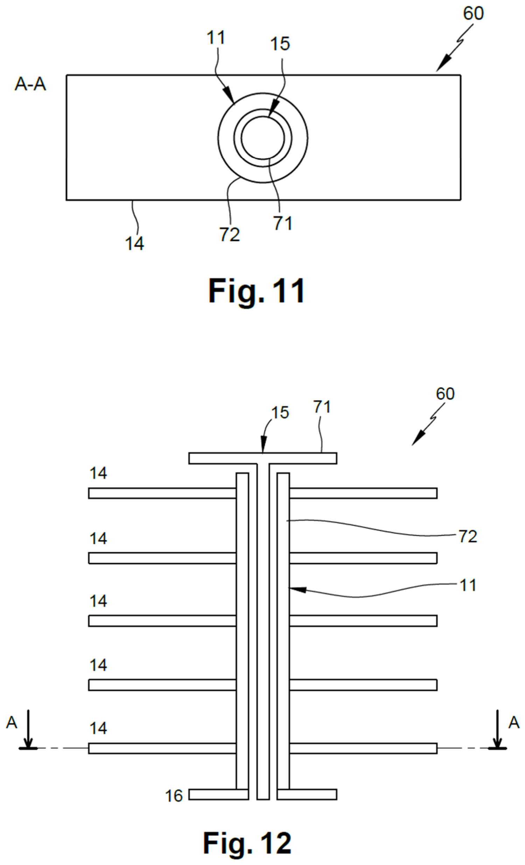

Dans ces figures, le transistor 10 comprend notamment une couche semi-conductrice ferroélectrique 11 (dite également « couche ferroélectrique ») s'étendant dans un plan. La couche ferroélectrique présente une première face dite « face supérieure » et une deuxième face dite « face inférieure », opposée à la face supérieure. La face supérieure est au-dessus de la face inférieure selon l'axe z des figures 1 et 2. Alternativement, la couche ferroélectrique 11 peut être un cylindre creux dans un système de type coeur/coquille (tel qu'illustré dans les figures 11 et 12). La face supérieure de la couche 11 correspond alors à une face extérieure du cylindre et la face inférieure de la couche 11 correspond à la face intérieure du cylindre.

Le transistor 10 des figures 1 et 2 comprend également des première, deuxième et troisième électrodes conductrices 14, 15 et 16. Elles forment respectivement une source 14 (également matérialisée par le terminal « S »), une grille 15 (également matérialisée par le terminal « G ») et un drain 16 (également matérialisé par le terminal « D »). La source et le drain 14, 16 s'étendent contre la face supérieure de la couche ferroélectrique 11. La grille 15 s'étend contre la face inférieure de la couche ferroélectrique 11. Ainsi, la couche ferroélectrique 11 est disposée entre, d'une part, la source et le drain 14, 16, et, d'autre part, la grille15.

Pour permettre un contrôle efficace d'une polarisation ferroélectrique 13 de la couche semi-conductrice ferroélectrique 11, la grille 15 est préférentiellement disposée en regard de la source 14. Dans un mode de réalisation, la grille 15 s'étend uniquement en regard de la source 14. Pour offrir un encombrement latéral minimum, elles sont préférentiellement de la même dimension et alignées l'une par rapport à l'autre (en suivant l'axe z des figures 1 et 2). Dans un autre mode de réalisation, correspondant aux figures 1 et 2, simplifiant la réalisation du transistor, la grille 15 s'étend sur une surface de la face inférieure de la couche ferroélectrique 11 correspondant à celle de la source 14 et du drain 16. La grille 15 est agencée pour être en regard de la source 14 et du drain 16. En particulier, la grille 15 s'étend en vis-à-vis des électrodes 14 et 16. L'application d'un potentiel électrique entre la source 14 et le drain 15 permet ainsi de créer un champ électrique entre la source 14 et la grille 15. La couche ferroélectrique 11, disposée entre ces électrodes 14, 15, baigne alors dans ce champ électrique. De la même manière, l'application d'un potentiel électrique entre le drain 16 et la grille 15 permet également de créer un champ électrique entre ces deux électrodes 16, 15, dans lequel baigne la couche ferroélectrique 11.

La couche ferroélectrique 11 comprend au moins un domaine ferroélectrique 12. Ce domaine 12 présente une polarisation électrique 13, apparaissant spontanément. Elle résulte par exemple de la somme vectorielle de moments dipolaires présents dans le premier domaine 12. Les moments dipolaires sont par exemple tous parallèles entre eux (configuration comparable aux moments magnétiques d'un domaine ferromagnétique). Les moments dipolaires peuvent également être orientés avec différents orientations, par exemple orientés de manière antiparallèle mais avec des amplitudes différentes (configuration comparable aux moments magnétiques d'un domaine ferrimagnétique) ou orientés perpendiculairement. Le domaine ferroélectrique présente par exemple une dimension latérale de quelques nanomètres à quelques dizaines de nanomètres.

La couche ferroélectrique 11 peut comprendre plusieurs domaines ferroélectriques, chacun d'eux étant porteur d'une polarisation électrique spontanée. Ces multiples domaines ferroélectriques peuvent être en interaction et se comporter comme un domaine ferroélectrique unique (c'est à dire que les polarisations électriques spontanées sont orientées de manière uniforme) à ceci près qu'il présente une taille plus importante (ce domaine de grande taille pourra être nommé « grand domaine ferroélectrique »). La polarisation électrique 13 correspond donc à la somme vectorielle des polarisations électriques des multiples domaines en interaction. Alternativement, les multiples domaines ferroélectriques peuvent être découplés les uns des autres mais interagir de la même manière avec les autres éléments du transistor 10. Par exemple, une pluralité de domaines électriques peut être disposée sous l'électrodes de source 14 ou de drain 15. Dès lors, ces multiples domaines découplés peuvent être confondus avec un grand domaine ferroélectrique unique (c'est à dire que les différentes polarisations électriques spontanées, subissant les mêmes transformations, présentent une orientation finale uniforme). La polarisation électrique 13 correspond donc à la somme vectorielle des polarisations électriques des multiples domaines découplés.

Un domaine ferroélectrique peut présenter une surface caractéristique (par exemple une surface de section) inférieure ou égale à la moitié de la surface de contact entre la source 14 et la couche ferroélectrique 11. Cette surface caractéristique est par exemple comprise entre 5 nm et 50 nm.

La polarisation ferroélectrique 13 présente au moins deux états distincts et stables. Par « états », on entend des directions et amplitudes particulières de la polarisation 13. Par « état stable », on entend un état que la polarisation 13 peut adopter pendant un temps suffisamment long, par exemple au regard de l'utilisation visée du transistor 10 (par exemple de l'ordre de la nanoseconde pour le calcul à la dizaine d'année pour le stockage d'information). Dans les figures 1 et 2, les deux états stables de la polarisation 13 sont perpendiculaires au plan dans lequel s'étend la couche ferroélectrique 11. Ils présentent la même amplitude (la flèche représentée fait la même taille) ; en revanche ils sont orientés différemment. La polarisation 13 est orientée vers le haut dans la figure 1 et vers le bas dans la figure 2.

La polarisation ferroélectrique 13 peut également présenter une pluralité d'états intermédiaires stables. Il peut s'agir d'états intermédiaires présentant une même direction (par exemple perpendiculaire au plan de la couche ferroélectrique 11) et avec des amplitudes différentes. Il peut également s'agir d'états présentant des directions différentes et une même amplitude. Il peut également s'agir d'une combinaison de ces deux types d'états stables. Ce qui peut être important pour le transistor 10 (discuté ci-après) est la composante hors-plan de la polarisation électrique 13. Par « composante hors-plan », on entend une composante perpendiculaire à l'interface entre la couche ferroélectrique 11 et l'électrode 14. La composante hors-plan de la polarisation électrique 13 peut prendre plusieurs valeurs et ceci de différentes manières. Les moments dipolaires donnant naissance à la polarisation électrique 13 peuvent être orientés hors du plan de la couche ferroélectrique 11 mais ils peuvent présenter des configurations pour lesquelles les sommes vectorielles sont différentes. Par exemple, les moments dipolaires peuvent passer d'une configuration antiparallèle à parallèle (comparable à la transformation d'un matériau ferromagnétique en matériau ferrimagnétique) ou perpendiculaire à parallèle. Les moments dipolaires peuvent rester parallèles (ou antiparallèle ou encore perpendiculaire) mais présenter différentes orientations par rapport au plan de la couche ferroélectrique 11. Dans ce cas, la composante hors-plan est nulle lorsque les moments dipolaires sont parallèles au plan de la couche ferroélectrique 11, et maximum quand ils sont perpendiculaires au plan de la couche ferroélectrique 11.

Une information peut être stockée dans le transistor 10 et peut correspondre à un des états de la polarisation 13. Lorsque la polarisation 13 peut prendre deux états distincts, elle peut alors stocker une information binaire. Lorsque la polarisation 13 peut prendre une pluralité d'états distincts, elle peut alors stocker une information non binaire mais comprenant au plus autant d'états que la polarisation 13 peut adopter. Dans un développement, la polarisation 13 peut présenter un nombre important d'états intermédiaires stables de manière à former une plage continue d'états stables. La polarisation 13 peut donc prendre une pluralité d'états distincts dans cette plage continue d'états stables. Ainsi, la polarisation 13 peut être utilisée pour stocker une information analogique, tel qu'un poids synaptique. L'obtention d'états intermédiaires pour la polarisation 13 peut être facilitée par la mise en œuvre d'un domaine 12 comprenant une pluralité de petits domaines.

Les source, grille et drain 14, 15, 16 sont agencés de manière à appliquer un champ électrique sur le domaine ferroélectrique 12, afin de pouvoir agir sur la polarisation électrique 13. Ainsi, l'application d'un potentiel entre la source 14 et le drain 15 et/ou entre la grille 15 et le drain 16 permet d'appliquer un champ électrique sur le domaine ferroélectrique 12 et de mettre ainsi la polarisation 13 dans un de ses états stables. La source 14 et la grille 15 sont avantageusement disposées de sorte que le champ appliqué sur la couche ferroélectrique 11 soit le long d'un axe de polarisation ferroélectrique du domaine ferroélectrique 12. De la sorte, le champ électrique est plus susceptible de réaliser une commutation de la polarisation ferroélectrique du domaine 12. Il en est de même pour la disposition du drain 16 et de la grille 15 lorsque ces électrodes sont destinées à contrôler également la polarisation ferroélectrique.

Afin d'éviter la circulation d'un courant électrique lors de l'application du champ électrique sur la couche ferroélectrique 11, la grille 15 peut être électriquement isolée de la couche ferroélectrique 11. Elle l'est par exemple au moyen d'une couche isolante (telle qu'une couche réalisée en oxyde de type SiO₂ ou HfO₂, ou en nitrure de type Si₃N₄, ou leur combinaison) séparant la grille 15 et la couche ferroélectrique 11.

De manière générale, la mise en contact d'un métal avec un matériau semi-conducteur peut déformer les bandes de valence et de conduction du matériau semi-conducteur et induire la formation d'une barrière de potentiel à l'interface entre les deux matériaux, appelée « barrière Schottky ».

Dans le transistor 10 selon l'invention, la source 14 forme, avec la couche ferroélectrique 11, une barrière Schottky 17. La barrière Schottky 17 est localisée à l'interface entre les deux matériaux. La source 14 est par exemple métallique et est en contact direct avec la couche ferroélectrique 11 afin de former la barrière Schottky 17. De manière générale, la personne du métier sait choisir une combinaison de matériaux permettant d'obtenir une barrière Schottky.

Les diagrammes de bandes des figures 1 et 2 montrent un exemple d'énergie E en fonction d'une hauteur z dans le transistor 10 pour la bande de conduction de la source 14 et les bandes de valence et de conduction de la couche ferroélectrique 11. Le niveau de Fermi E_{F} des matériaux est indiqué en pointillés. Loin de l'interface, les bandes de valence et de conduction de la couche ferroélectrique 11 ne sont pas déformées. Au niveau de l'interface avec le métal de la source 14, les bandes de la couche ferroélectrique 11 se déforment de sorte que le niveau de Fermi sorte de la bande de conduction. Dans le diagramme de bandes de la figure 1, une portion C de la bande interdite forme alors une barrière au passage de charges (en particulier des électrons) provenant du métal de la source 14 vers le semi-conducteur de la couche ferroélectrique 11. Cette portion C forme alors la barrière Schottky 17.

La déformation des bandes donnant lieu à la barrière Schottky 17 peut dépendre d'un champ électrique au niveau de l'interface entre les deux matériaux. Un champ électrique suffisamment fort et suffisamment proche peut réduire la déformation des bandes et réduire, voire annuler, la barrière Schottky 17. Le diagramme de bandes de la figure 2 montre un exemple où le niveau de Fermi reste dans la bande de conduction, bien que les bandes soient déformées. Ainsi, moduler le champ électrique au niveau de l'interface métal/semi-conducteurs permet de moduler la hauteur et/ou la largeur de la barrière Schottky 17, ce qui revient à moduler la résistance électrique de la barrière Schottky 17. Dans un cas particulier, lorsque la barrière Schottky 17 est complètement annulée (cas de la figures 2), la résistance de la barrière Schottky 17 est minimale. Elle correspond par exemple à une résistance de contact ohmique entre les deux matériaux.

Le transistor 10 de l'invention prévoit que le champ électrique permettant de moduler la résistance de la barrière Schottky 17 est induit par la polarisation ferroélectrique 13. En utilisant un matériau semi-conducteur et ferroélectrique, le champ électrique proche de l'interface est suffisamment élevé pour moduler efficacement la hauteur et/ou la largeur de la barrière Schottky 17. Ainsi, placer la polarisation 13 dans ses différents états revient à moduler le champ électrique au niveau de la barrière Schottky 17. La modulation du champ électrique se traduit alors par une modulation de la résistance de la barrière Schottky 17. Ainsi, mesurer la résistance de la barrière Schottky 17 permet de déterminer l'état dans lequel se trouve la polarisation 13.

Les matériaux susceptibles de former la source 14 peuvent être choisis en fonction du type de dopage du matériau formant la couche semi-conductrice ferroélectrique 11. Chaque matériau est choisi pour ajuster la hauteur de barrière Schottky en fonction de son travail de sortie. Si le semi-conducteur est par exemple de type n, le travail de sortie de la source 14 est choisi supérieur à l'affinité électronique du semi-conducteur. Inversement si le semi-conducteur est dopé p, le travail de sortie de l'électrode conductrice est choisi inférieur à l'affinité électronique du semi-conducteur. Les matériaux susceptibles de former la source 14 sont toutefois préférentiellement choisis pour que l'amplitude de la barrière Schottky 17 varie de manière mesurable en fonction de la polarisation 13 de la couche ferroélectrique 11. Pour choisir un couple de matériaux pertinents, une étape comprend la sélection d'un matériau destiné à former la couche semi-conductrice ferroélectrique 11 du transistor 10. Une seconde étape comprend la formation d'une couche d'essai, présentant les mêmes dimensions que la couche semi-conductrice ferroélectrique. Une troisième étape comprend une mesure d'une variation de champ électrique à la surface de la couche d'essai, pour différents états de la polarisation de la couche d'essai. Enfin, une quatrième étape comprend la sélection d'un matériau destiné à former la source 14, en fonction de son travail de sortie, de l'amplitude de variation du champ électrique mesurée sur la couche d'essai et de l'affinité électronique du matériau semi-conducteur utilisé pour former la couche d'essai. Le matériau destiné à former la source 14 présente par exemple un travail de sortie tel que la hauteur de la barrière Schottky susceptible d'être formée est modulée de plus de 5 %, et préférentiellement de plus de 10%, et de manière encore préférée de plus de 80 %, pour deux états de polarisation distincts. Lorsque la couche ferroélectrique est en silicium dopé de type n, la source 14 est par exemple en Platine.

En conséquence du paragraphe précédent, il est possible d'imaginer un matériau ferroélectrique semi-conducteur non-dégénéré que l'on vient doper localement pour le rendre dégénéré soit de type n soit de type p. En prenant soin de choisir les électrodes métalliques adaptées dans chaque cas, on peut ainsi obtenir des caractéristiques analogues à la complémentarité des transistors CMOS. Pour une même tension d'écriture appliquée sur un dispositif dopé p ou dopé n, on obtient ainsi des états de résistance opposés.

La couche ferroélectrique 11 présente une épaisseur de quelques couches atomiques (par exemple supérieure à 2 Å) à quelques centaines de nanomètres (par exemple inférieure à 500 nm), et avantageusement de l'ordre de la dizaine de nanomètres (par exemple comprise entre 5 nm et 50 nm).

La résistance de la barrière Schottky 17 varie préférentiellement selon une fonction strictement monotone de la composante hors-plan de la polarisation 13 (c'est-à-dire la composante de la polarisation 11 qui est orthogonale au plan de la couche ferroélectrique 11). De la sorte, la correspondance entre la résistance de la barrière Schottky 17 et l'état de la polarisation 13 est bijective.

Par « monotone », on entend une fonction dont la dérivée est positive ou nulle (ou respectivement négative ou nulle). Par « strictement monotone », on entend une fonction dont la dérivée est strictement positive (ou strictement négative).

Dans le cas où la composante hors-plan de la polarisation 13 présente une plage continue d'états stables, la barrière Schottky 17 peut montrer une plage continue de valeurs de résistance associées. Le transistor 10 permet alors de stocker et lire une information analogique plutôt que numérique.

Le domaine ferroélectrique 12 peut comprendre une pluralité de domaines ferroélectriques. L'interaction de la composante hors-plan des moments dipolaires de ces domaines avec la barrière Schottky 17 est alors intégrée sur la totalité de la surface de la barrière Schottky 17, c'est à dire sur la surface de contact entre la source 14 et la couche ferroélectrique 11.

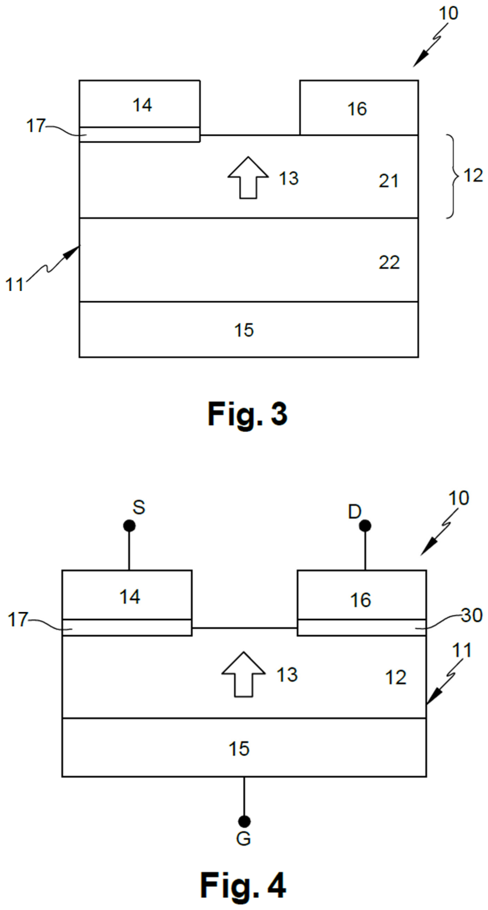

Pour mesurer efficacement la résistance de la barrière Schottky 17, il peut être prévu de mesurer la variation de résistance entre la source 14 et le drain 16. Ce chemin électrique peut être vu comme un chemin dit « de lecture ». Afin de mesurer la variation de résistance de la barrière Schottky 17 avec une bonne précision possible, le drain 16 est en contact électrique avec la couche ferroélectrique 11. Dans un premier cas de figure, le contact électrique entre le drain 16 et la couche ferroélectrique 11 peut présenter une résistance indépendante de la polarisation 13. Le drain 16 forme par exemple un contact ohmique avec la couche ferroélectrique. Le contact peut également être réalisé par l'intermédiaire d'une fine couche, formant par exemple une barrière de diffusion, une couche protectrice, une couche favorisant un certain type de croissance ou une couche isolante permettant le passage d'un courant par effet tunnel. Dans un deuxième cas de figure, par exemple présenté en référence à la figure 4, le contact électrique entre le drain 16 et la couche ferroélectrique 11 présente une résistance électrique qui est également fonction de la polarisation ferroélectrique 13. Le contact forme par exemple une deuxième barrière Schottky, dont la résistance équivalente est également fonction de la polarisation 13.

Le transistor 10 peut permettre de :
- contrôler l'état de la polarisation 13 en appliquant un potentiel entre la source 14 et la grille 15 (le chemin électrique entre la source 14 et la grille 15 formant un chemin dit « d'écriture ») ; et
- lire l'état de la polarisation 13 en mesurant la résistance de la barrière Schottky 17, c'est-à-dire en mesurant la résistance totale entre la source 14 et le drain 16 (c'est-à-dire le long du chemin de lecture).

Pour que la polarisation 13 ne soit pas perturbée pendant la lecture de la résistance de la barrière Schottky 17, le drain 16 est préférentiellement disposé de sorte que le champ appliqué sur le domaine ferroélectrique 12 lors de la lecture (c'est-à-dire lorsqu'un potentiel est appliqué entre la source 14 et la grille 15) ne soit pas le long d'un axe de polarisation ferroélectrique (c'est-à-dire le long d'un axe correspondant à un état stable de la polarisation 13). De manière avantageuse, la source 14 et le drain 16 sont disposés de sorte que la couche ferroélectrique 11 ne soit pas disposée entre ces électrodes 14, 16. Dans l'exemple des figures 1 et 2, la source 14 et le drain 16 sont disposés sur une même face (en l'occurrence la face supérieure) de la couche ferroélectrique 11. Ainsi, il n'y a aucune partie de la couche ferroélectrique 11 qui est située entre ces électrodes 14, 16. Le champ électrique ainsi crée entre les électrodes 14 et 16 est majoritairement le long du plan et n'affecte que peu, voire pas, la composante hors-plan de la polarisation ferroélectrique 13. La lecture de l'état du transistor 10 peut être réalisée sans risquer de commuter non-intentionnellement la polarisation 13.

Il est toutefois possible d'agencer le drain 16 autrement, dès lors que cette dernière est en contact électrique avec la couche ferroélectrique 11. Le drain 16 peut par exemple être disposé contre la face inférieure de la couche ferroélectrique 11, à proximité de la grille 15 (mais sans contact électrique avec cette dernière). Elle peut également être disposée sur un côté ou un bord de la couche ferroélectrique 11 (mais sans contact avec la source 14 ou la grille 15). Pour éviter de perturber la polarisation 13, il peut encore suffire d'utiliser une tension de lecture de faible amplitude.

Afin d'améliorer la lecture de la résistance de la barrière Schottky 17, il est avantageux que la résistance totale entre la source 14 et le drain 16 soit la plus faible possible, préférentiellement inférieure à 10 kΩ. Une manière d'y parvenir est de doper la couche ferroélectrique 11 afin d'accroître sa conductivité. De manière préférée, la couche ferroélectrique 11 est conductrice à température ambiante. Elle peut être dégénérée, de manière intrinsèque ou par un dopage adéquat. De la sorte, la couche ferroélectrique 11 peut montrer une conductivité électrique proche de la conductivité d'un métal, par exemple à température ambiante, et il n'est pas nécessaire que cette conductivité dépende, comme dans un FeS-FET ou un FEFET, de l'état de polarisation 13. Les diagrammes de bandes des figures 1 et 2 illustrent une couche ferroélectrique 11 dégénérée où le niveau de Fermi est dans la bande de conduction. Le matériau ferroélectrique α-GeTe est intrinsèquement dégénéré (autrement dit naturellement dégénéré) et convient de manière remarquable à l'invention. La couche ferroélectrique 11 peut également être réalisée à partir de α-In₂Se₃ suffisamment dopé pour rendre la couche ferroélectrique 11 dégénérée.

De plus, ces deux matériaux (α-GeTe dégénéré et α-In₂Se₃ dégénéré), bien qu'ils présentent une polarisation ferroélectrique, présentent également une conductivité électrique indépendante de leur polarisation.

Le transistor 10 illustré aux figures 1 et 2 peut être employé en tant que transistor conventionnel, grâce à sa configuration mettant en œuvre trois électrodes conductrices. Ainsi, la conductivité électrique entre la source 14 et le drain 16 peut être modulée en modifiant la résistance de la barrière Schottky 17. Le transistor 10 de l'invention présente toutefois l'avantage de conserver le même niveau de conductivité entre la source 14 et le drain 16 même lorsque le transistor 10 n'est plus alimenté. Autrement dit, le transistor 10 selon l'invention est non-volatil.

Pour former la source 14 et le drain 16, il est préférable qu'il n'y ait pas de contamination entre la source et/ou le drain et la couche ferroélectrique. Idéalement le dépôt de la couche (par exemple métallique) destinée à former la source et/ou le drain, est réalisée juste après le dépôt de la couche ferroélectrique 11, préférentiellement sans remise à l'air de la couche ferroélectrique 11 entre les deux étapes. Dans une variante, une fine couche (par exemple une barrière de diffusion, une couche isolante ou une couche favorisant une croissance particulière) peut être déposée sur la couche ferroélectrique 11, avant le dépôt de la couche destinée à former la source et/ou le drain. La couche destinée à former la source et/ou le drain peut alors être déposée sur cette fine couche. Cette fine couche peut éventuellement empêcher la contamination de la couche ferroélectrique si une remise à l'air est nécessaire avant le dépôt de la couche destinée à former la source et/ou le drain.

Par « fine couche », on entend une couche pour laquelle l'épaisseur est suffisamment faible pour ne pas empêcher la formation d'une barrière Schottky ou un contact ohmique. Cette épaisseur est par exemple inférieure à la longueur de Thomas-Fermi de la couche ferroélectrique 11 et/ou du matériau formant la couche destinée à former la source et/ou le drain.

La figure 3 présente un mode de réalisation du transistor qui diffère du mode des figures 1 et 2 en ce que la couche ferroélectrique 11 comprend une première sous-couche semi-conductrice ferroélectrique 21 et une deuxième sous-couche 22. Dans ce mode de réalisation, la source 14 et le drain 16 sont en contact électrique avec la première sous-couche ferroélectrique 21. Ainsi, la source 14 forme une barrière Schottky 17 avec la première sous-couche 21. La grille 15 s'étend contre la deuxième sous-couche 22.

Il peut être difficile de renverser la polarisation d'un ferroélectrique dégénéré à cause du courant de fuite qui circule lors de l'application d'une tension sur le ferroélectrique. Dans le cas où la couche ferroélectrique 11 comprend deux sous-couches 21, 22, il est avantageux que les conductivités de ces deux sous-couches 21, 22 soient différentes. Préférentiellement, la deuxième sous-couche 22 présente une conductivité électrique inférieure à la conductivité électrique de la première sous-couche ferroélectrique 21, par exemple inférieure à 10 % de la conductivité électrique de la première sous-couche ferroélectrique 21. Ainsi, lors de la lecture de la résistance de la barrière Schottky 17 ou lors de son exposition à un champ électrique, le courant de fuite circulant vers la grille 15 est réduit. En revanche, la faible conductivité électrique de la deuxième sous-couche 22 facilite l'application d'un champ électrique sur la couche ferroélectrique 11 (par exemple pour commuter sa polarisation). Ainsi, la polarisation 13 peut être commutée avec une tension faible. Lorsque la conductivité électrique de la deuxième sous-couche 22 est suffisamment faible (par exemple inférieure à 10 % de la conductivité électrique de la première sous-couche ferroélectrique 21, voire davantage), elle peut se substituer à une couche isolante entre la couche ferroélectrique 11 et la grille 15. Dans un exemple de réalisation, la deuxième sous-couche 22 est simplement isolante.

La deuxième sous-couche 22 peut également être ferroélectrique. Ainsi, en plus de limiter le courant de fuite qui pourrait circuler vers la grille 15, elle permet de faciliter la commutation de la polarisation électrique de la première sous-couche ferroélectrique 21. En effet, l'application d'un champ électrique sur la deuxième sous-couche ferroélectrique 22 permet de commuter des domaines ferroélectriques (qui peuvent être verticaux) qui induisent à leur tour une commutation des domaines ferroélectriques de la première sous-couche ferroélectrique 21. Dans un état final, les deux sous-couches 21, 22 peuvent présenter les mêmes sens de polarisation.

La résistance de la barrière Schottky 17 est influencée par la polarisation de la sous-couche ferroélectrique avec laquelle la source 14 est en contact. Il s'agit dans cet exemple de la première sous-couche ferroélectrique 21. Il est indifférent, du point de vue de l'influence sur la résistance de la barrière Schottky 17, que la polarisation 13 soit portée uniquement par la première sous-couche 21 ou par l'ensemble des deux sous-couches 21, 22. En d'autres termes, le domaine ferroélectrique 12 peut appartenir à la première sous-couche 21 ou à l'ensemble des sous-couches 21, 22. La deuxième sous-couche ferroélectrique 22 permet de faciliter la commutation de la première sous-couche 21. La deuxième sous-couche peut être dimensionnée pour commuter à plus faible tension et entrainer la commutation des domaines ferroélectriques de la première sous-couche par propagation verticale des domaines ferroélectriques.

Le mode de réalisation de la figure 4 diffère du mode de réalisation des figures 1 et 2 en ce que le transistor 10 comprend une barrière Schottky supplémentaire 30. Autrement dit, le transistor 10 comprend deux barrières Schottky 17, 30. La première barrière Schottky 17 est localisée au niveau de l'interface entre la couche ferroélectrique 11 et la source 14 (il s'agit de la barrière Schottky décrite précédemment). La deuxième barrière Schottky 30 (également appelée barrière Schottky supplémentaire) est localisée à l'interface entre la couche ferroélectrique 11 et le drain 16. Dans ce cas, le drain 16 est par exemple en métal et en contact direct avec la couche ferroélectrique 11 (il peut être dimensionné de la façon décrite précédemment, en référence à la première barrière Schottky 17).

Dans ce mode de réalisation, la résistance de la deuxième barrière 30 est fonction de la polarisation 13. Ainsi, la mesure de la résistance totale entre la source 14 et le drain 16 comprend la somme des résistances des première et deuxième barrières 17, 30. La variation de la résistance totale associée à la modulation de la polarisation 13 est donc augmentée, améliorant d'autant la lecture. Bien entendu, il est préférable que la deuxième barrière 30 soit fonction monotone de la polarisation 13 et suivant la même tendance que la première barrière Schottky 17 (c'est-à-dire toutes les deux croissantes en fonction de la polarisation 13 ou toutes les deux décroissantes en fonction de la polarisation 13).

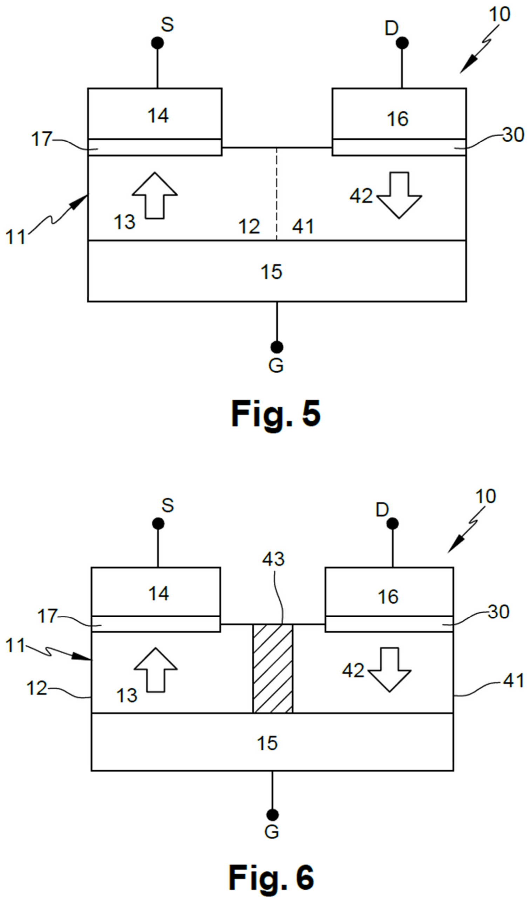

Les figures 5 à 7 présentent trois modes de réalisation du transistor 10 permettant de stocker deux informations distinctes.

À la différence des modes de réalisation des figures 1 à 4, pour lesquels la couche ferroélectrique 11 ne comprend qu'un seul domaine ferroélectrique, le transistor 10 des figures 5 à 7 présente donc deux domaines ferroélectriques 12, 41, distincts l'un de l'autre. Le premier domaine ferroélectrique 12 correspond par exemple au domaine ferroélectrique présenté précédemment, en référence aux figures 1 à 4. Le transistor 10 présente un deuxième domaine ferroélectrique 41, distinct du premier domaine ferroélectrique 12. Le deuxième domaine ferroélectrique 41 présente une deuxième polarisation électrique 42 spontanée, distincte de la première polarisation 12 (autrement dit découplée de cette dernière). La deuxième polarisation électrique 42 spontanée peut prendre une pluralité d'états de polarisation. Le transistor 10 comprend donc une pluralité de polarisations 13, 42 distinctes, permettant de stocker une pluralité d'informations distinctes.

Dans les modes de réalisation des figures 5 à 7, les premier et deuxième domaines ferroélectriques 12, 41 peuvent être des domaines ferroélectriques distincts ou des ensembles de domaines ferroélectriques (couplés ou non) et formant des grands domaines ferroélectriques tels que décrit précédemment.

La source 14 et le drain 16 sont préférentiellement suffisamment éloignés l'un de l'autre pour que l'interaction entre les premier et deuxième domaines 12, 41 soit négligeable. La distance séparant la source 14 et le drain 16 est par exemple supérieure à l'épaisseur d'une paroi de domaine séparant les deux domaines ferroélectriques 12, 41. Dans un développement, les deux domaines ferroélectriques 12, 41 peuvent être séparés par au moins un troisième domaine ferroélectrique. La source 14 et le drain 16 sont alors séparés l'un de l'autre d'une distance correspond au troisième domaine.

Alternativement, et tel qu'illustré en figure 6, la couche ferroélectrique 11 est séparée en deux portions distincts par une troisième portion 43 conductrice mais non ferroélectrique, dite « espaceur ». L'espaceur 43 permet de réduire l'interaction entre les premier et deuxième domaines ferroélectriques 12, 41. L'espaceur 43 est préférentiellement en contact ohmique avec chacune des deux portions de la couche semi-conductrice ferroélectrique 11. De la sorte, il permet à un courant électrique de circuler de la première portion à la deuxième portion et inversement. L'espaceur 43 est par exemple métallique. Il peut être important d'éviter tout contact direct entre l'espaceur 43 et la source 14, la grille 15 ou le drain 16, afin d'éviter tout court-circuit.

Dans les modes de réalisation des figures 5 et 6, l'application d'une tension entre la source 14 et la grille 15 et entre le drain 16 et la grille 15, permet d'appliquer un champ électrique sur, respectivement, les premier et deuxième domaines 12, 41. Les première et deuxième polarisations 13, 42 de ces domaines peuvent ainsi être contrôlées indépendamment l'une de l'autre. La source 14 et le drain 16 sont préférentiellement agencées, vis-à-vis des premier et deuxième domaines 12, 41 et de la grille 15, de sorte que les champs électriques générés ne soient pas alignés avec un axe de polarisation d'un domaine qu'ils ne sont pas censés contrôler. Par exemple, aucune portion du premier domaine ferroélectrique 12 n'est localisée entre le drain 16 et la grille 15. Ainsi, aucun champ électrique généré entre le drain 16 et la grille 15 n'est aligné avec un axe de polarisation du premier domaine ferroélectrique 12.

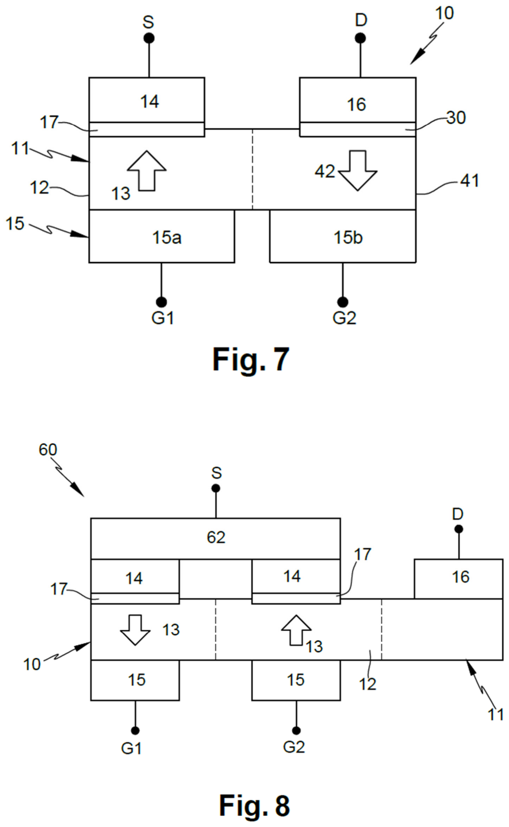

Afin de renforcer l'indépendance dans le contrôle des polarisation 13, 42, la grille 15 peut comprendre deux portions distinctes 15a, 15b, telles qu'illustrées à la figure 7. Les deux portions de grille 15a, 15b sont séparées l'une de l'autre et séparées de la source 14 et du drain 16. Les deux portions de grille 15a, 15b s'étendent contre la face inférieure de la couche ferroélectrique 11 et à l'aplomb de, respectivement, la source 14 et le drain 16. Le premier domaine 12 est ainsi disposé entre la source 16 et la première portion de grille 15a. Et le deuxième domaine 41 est disposé entre le drain 16 et la deuxième portion de grille 15b. Ainsi, les deux portions de grille 15a, 15b sont agencées de sorte que :
- la source 14 et la première portion de grille 15a puissent appliquer un champ électrique sur le premier domaine ferroélectrique 12 ;
- le drain 16 et la deuxième portion de grille 15b puissent appliquer un champ électrique sur le deuxième domaine ferroélectrique 41.

Le champ électrique appliqué entre le drain 16 et la deuxième portion de grille 15b reste localisé au niveau du deuxième domaine 41, porteur de la deuxième polarisation 42, en influençant de manière réduite, voire nulle, le premier domaine 12. De manière similaire, la première portion de grille 15a ne s'étend pas contre toute la face inférieure de la couche ferroélectrique 11. Ainsi, le champ électrique appliqué entre la source 14 et la première portion de grille 15b reste localisé au niveau du premier domaine 12, porteur de la première polarisation 13, en influençant de manière réduite, voire nulle, le deuxième domaine 41.

Les deux portions de grille 15a, 15b sont préférentiellement électriquement isolées de la couche ferroélectrique 11, par exemple par une couche isolante. Il peut s'agir de la même couche qui isole la grille 15 monolithique des figures 1 à 4.

Les modes de réalisation des figures 5 à 7 sont particulièrement bien adaptés à un fonctionnement selon un principe logique « ET ». On parle alors de « porte logique ET » ou de « fonction ET ». Dans ces modes de réalisation, le transistor comprend deux barrières Schottky 17, 30. La source 14 est en contact électrique avec le premier domaine ferroélectrique 12 avec lequel elle forme la première barrière Schottky 17. Le drain 16 est en contact électrique avec le deuxième domaine ferroélectrique 41 avec lequel il forme la deuxième barrière Schottky 30. Ainsi, la résistance de la deuxième barrière Schottky 30 n'est pas fonction de la première polarisation 13, comme c'est le cas dans la figure 4. Elle est fonction de la deuxième polarisation 42, portée par le deuxième domaine ferroélectrique 41. La deuxième barrière Schottky 30 permet donc de déterminer l'état de la deuxième polarisation 42 du deuxième domaine ferroélectrique 41.

La résistance totale entre la source 14 et le drain 16 comprend en outre la somme des résistances des première et deuxième barrières Schottky 17, 30. Dès lors, il suffit que l'une de ces deux barrières 17, 30, voire les deux barrières 17, 30, soit/soient dans un état de forte résistance pour que la résistance totale entre la source 14 et le drain 16 soit également élevée. Il n'y a que lorsque les deux barrières 17, 30 présentent simultanément une faible résistance que la résistance totale entre la source 14 et le drain 16 est faible.

Le tableau ci-dessous résume le fonctionnement des transistors des figures 5 à 7. Pour cet exemple, les première et deuxième polarisations 13, 42 notées P1 et P2, peuvent prendre deux états distincts « 0 » ou « 1 » pour lesquels les résistances de barrière Schottky R_{B1}, R_{B2} peuvent respectivement prendre les valeurs « haute » et « basse ». La résistance totale entre la source 14 et le drain 16 est indiquée par R₁₃ et l'état final associé est indiqué en dernière colonne.

| P₁ | R_{B1} | P₂ | R_{B2} | R₁₃ | État final |
|---|---|---|---|---|---|
| 0 | haute | 0 | haute | haute | 0 |
| 0 | haute | 1 | basse | haute | 0 |
| 1 | basse | 0 | haute | haute | 0 |
| 1 | basse | 1 | basse | basse | 1 |

Les figures 8 à 10 présentent trois modes de réalisation d'un assemblage 60 de transistors 10, tirant parti d'une propriété remarquable des transistors 10. En effet, pour chaque transistor 10, la conductivité électrique dans la couche ferroélectrique 11 n'est pas modifiée par les différents états que peuvent prendre les différentes polarisations de ladite couche 11. La seule modification de conductivité a lieu à l'interface entre la couche ferroélectrique 11 et la source 14 (et le drain 16 lorsqu'il y a une autre barrière Schottky). Dès lors, en dehors de ces interfaces, la couche ferroélectrique 11 peut être utilisée comme une piste de conduction. Une seule et même couche ferroélectrique 11 peut par exemple être mutualisée entre plusieurs transistors 10.

Les assemblages 60 des figures 8 à 9 comprennent une couche ferroélectrique 11 comprenant une pluralité de domaines ferroélectriques 12. Chaque domaine 12 est porteur d'une polarisation spontanée 13. Les domaines 12 sont électriquement connectés entre eux mais suffisamment distants pour ne pas s'influencer mutuellement. Les assemblages 60 comprennent également une pluralité de sources 14 s'étendant contre la couche ferroélectrique 11, au niveau de chaque domaine 12 et formant une barrière Schottky 17 avec la couche ferroélectrique 11. Une grille 15, unique ou présentant des portions, s'étend contre la couche ferroélectrique 11 et est agencée en regard des sources 14. Les sources 14 sont par exemple disposées contre la face supérieure de la couche ferroélectrique 11 et la grille 15 (ou chaque portion de grille) s'étend contre la face inférieure de la couche ferroélectrique 11, opposée à la couche supérieure. Enfin un drain 16, unique et commun à toutes les sources 14, s'étend contre la couche ferroélectrique 11. Dans ces exemples, le drain 16 commun s'étend sur la face supérieure de la couche ferroélectrique 11, sur la même face que les sources 14. La couche ferroélectrique 11 peut être dégénérée localement, notamment au niveau de ses interfaces avec les différentes sources 14. Toutefois, il est avantageux que toute la couche ferroélectrique 11 soit dégénérée, de manière à offrir un rapport ON/OFF élevée pour chaque barrière Schottky 17.

Chaque couple source 14/barrière Schottky 17/drain 16 forme alors un transistor 10 selon l'invention. L'assemblage 60 correspond donc à une pluralité de transistors 10 selon l'invention, dont la couche ferroélectrique 11 est commune et dont le drain 16 est commun.

De manière remarquable, les domaines ferroélectriques 12 font alors partie de la même couche ferroélectrique 11. Puisque la conductivité dans la couche ferroélectrique 11 n'est pas influencée par l'état de chaque polarisation 13, peu importe qu'il y ait un ou plusieurs domaines entre la barrière Schottky 17 et le drain 16 commun, chaque transistor 10 peut donc être opéré de la même façon que le transistor 10 des figures 1 et 2. Pour déterminer l'état de polarisation d'une des polarisations, la mesure de la résistance de la barrière Schottky 17 associée est réalisée en mesurant la résistance totale entre la source 14 correspondante et le 16 commun. L'assemblage 60 permet de stocker plusieurs informations dans des domaines ferroélectriques 12 distincts tout en ne mettant en œuvre qu'une seule couche ferroélectrique 11. L'encombrement par unité d'information est donc réduit.

Dans l'exemple de la figure 8, l'assemblage 60 comprend deux transistors 10. De plus, les sources 14 sont électriquement liées l'une à l'autre. Ce mode de réalisation est particulier en ce qu'il est adapté à un fonctionnement selon un principe logique « OU ». On parle alors de « porte logique OU » ou de « fonction OU ». À la différence du transistor de la figure 7, l'assemblage de la figure 8 comprend une cinquième électrode 62 en contact électrique avec les deux sources 14 des deux transistors 10 et un drain 16 commun.

Pour fonctionner comme une porte logique OU, il est nécessaire que l'assemblage 60 soit en mesure de contrôler indépendamment les polarisations 13. Dans ce mode de réalisation, ce contrôle est assuré par les différentes portions de grille 15. Ainsi, appliquer un potentiel électrique sur les sources 14 et une seule portion de grille 15, permet de commuter indépendamment chaque polarisation 13.

Dans ce mode de réalisation, les barrières Schottky 17 sont connectées en parallèles. Ainsi, il suffit qu'une des deux barrières 17 soit passante (c'est à dire présente un état de faible résistance) pour que la résistance totale (entre l'électrode 62 et le drain 16) soit faible.

Le tableau ci-dessous résume le fonctionnement de l'assemblage de la figure 8. Dans cet exemple, les polarisations 13, notées P₁ et P₂, peuvent prendre deux états distincts « 0 » ou « 1 » pour lesquels les résistances de barrière Schottky R_{B1}, R_{B2} peuvent respectivement prendre les valeurs « haute » et « basse ». La résistance totale (entre l'électrode 61 et le drain 16) est indiquée par R_{TOT} et l'état final associé est indiqué en dernière colonne.

| P₁ | R_{B1} | P₂ | R_{B2} | R_{TOT} | État final |
|---|---|---|---|---|---|
| 0 | Haute | 0 | Haute | Haute | 0 |
| 0 | Haute | 1 | basse | basse | 1 |
| 1 | Basse | 0 | haute | basse | 1 |
| 1 | Basse | 1 | basse | basse | 1 |

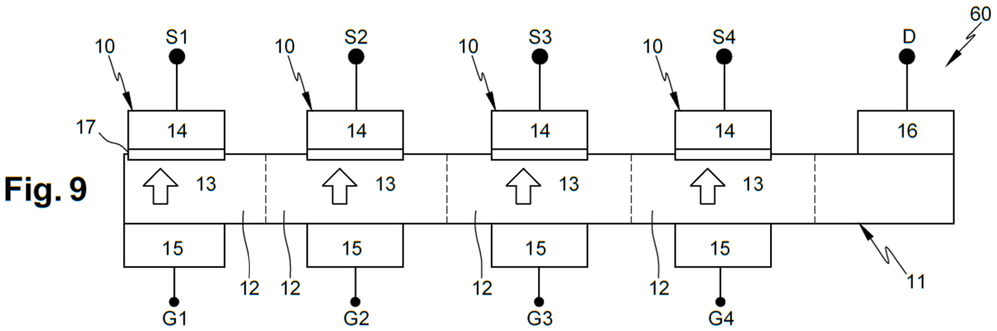

Dans l'exemple de la figure 9, l'assemblage 60 comprend quatre transistors 10 selon l'invention, similaires au transistor des figures 1 et 2, connectés en étoiles avec un drain 16 commun et des grilles et des sources 14 indépendantes. Le potentiel électrique à appliquer pour contrôler l'une des polarisations 13 est alors appliqué entre l'une des sources 14 et la grille 15 correspondante. Ainsi, le champ électrique appliqué au niveau de chaque domaine 12 est restreint spatialement.

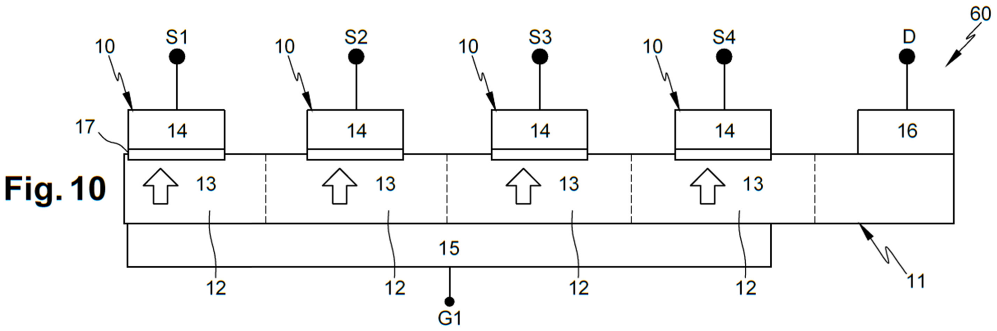

L'assemblage 60 de la figure 10 diffère de l'assemblage de la figure 9 en ce qu'elle comprend une grille 15 commune. Dans cet exemple, la grille 15 est agencée en regard de toutes les sources 14. Ce mode de réalisation simplifie la fabrication de la grille 15.

Les figures 11 et 12 illustrent un mode de réalisation de l'assemblage 60. Ce mode de réalisation représente une variante particulière du mode de réalisation de la figure 10. Dans ce cas, on peut parler d' « assemblage 3D », en référence aux trois dimensions de l'espace. Dans cet exemple particulier, l'assemblage 60 comprend un nanofil 71 et un nanotube 72, ledit nanotube 72 entourant le nanofil 71. Le nanofil 71 est conducteur et forme la grille 15 commune de l'assemblage 60 (et donc de chaque transistor 10 associé, comme dans la figure 10). Le nanotube 72 est réalisée en matériau semi-conducteur ferroélectrique, préférentiellement entièrement dégénéré, et forme la couche ferroélectrique 11 commune (et donc de chaque transistor). Dans un assemblage 3D, la couche ferroélectrique 11 et la grille 15 sont donc cylindriques. Le nanofil 71 et le nanotube 72 peuvent être séparés par une couche isolante, par exemple en oxyde, ou par une barrière de diffusion ou une couche de protection, ou une couche ferroélectrique 22 de plus faible conductivité (comme en figure 3).

Dans le mode de réalisation des figures 11 et 12, un drain 16 commun s'étend perpendiculairement à l'ensemble nanotube/nanofil 71, 72 et prend contact avec le nanotube 71 sur un bord de ce dernier. Une pluralité de sources 14, prenant la forme d'électrodes conductrices planes, s'étendent perpendiculairement à l'ensemble nanofil/nanotube 71, 72. Les sources 14 forment un contact contre le nanotube 72 en différents points de manière à former les transistors 10. Elles peuvent entourer partiellement ou en totalité le nanotube 72.

Dans une variante d'assemblage 3D, reprenant le principe de la figure 8, les transistors 10 peuvent présenter une source 14 commune, formée par exemple par le nanofil 72. Chaque transistor présente alors une grille 15 distincte, formée par l'une des électrodes conductrices planes entourant, au moins partiellement, le nanotube 72. Dans cette variante, le nanofil 71 est préférentiellement en contact avec le nanotube 72 tandis que les électrodes planes sont préférentiellement isolées du nanotube 71.

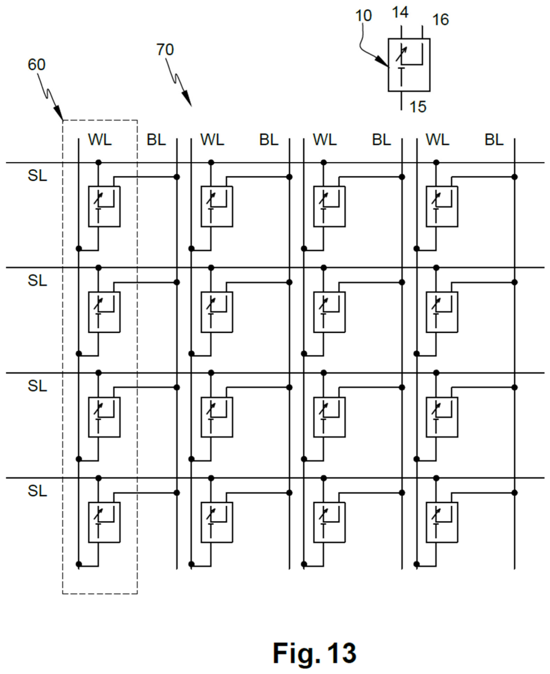

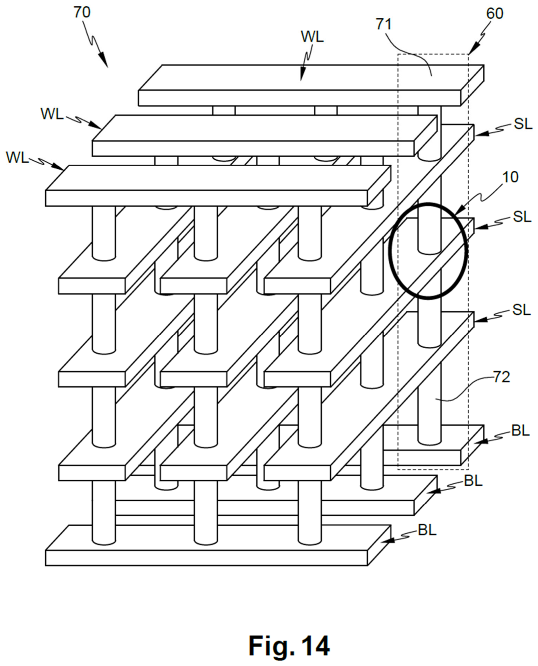

Les figures 13 et 14 présentent deux modes de réalisation d'une matrice de stockage non-volatile intégrant les transistors 10 décrits aux figures 1 à 4.

La figure 13 comporte en insert, une représentation simplifiée d'un transistor 10 selon l'invention. En particulier les source, grille et drain 14, 15, 16 y sont reportées.

La figure 13 présente une matrice 70 mettant en œuvre ces transistors 10. En particulier, la matrice 70 comprend :
- une première pluralité de lignes conductrices BL, dites « ligne de données » ;
- une deuxième pluralité de lignes conductrices WL, dites « ligne de mots » ; et
- une troisième pluralité de lignes conductrices SL, dites « ligne de source ».

Pour chaque transistor 10 :
- la source 14 est connectée à l'une des lignes de de source SL ;
- la grille 15 est connectée à l'une des lignes de mots WL ; et
- le drain 16 est connectée à l'une des lignes de données BL.

Les transistors 10 connectés à une même ligne de mots WL, peuvent faire partie d'un assemblage 60 tel que décrit précédemment, par exemple en référence aux figures 9 et 10. Dans la figure 13, quatre transistors 10 connectés à une même ligne de mots WL sont encadrés en pointillés. Ils peuvent faire partie d'un assemblage 60 tel que celui représenté en figure 9 ou 10. Par exemple, suivant l'exemple de l'assemblage 60 de la figure 10, les transistors 10 connectés à la même ligne de mots WL présenteraient une grille 15 commune.

La figure 14 présente un mode de réalisation de la matrice comprenant une pluralité de transistors 10 et où chaque transistor 10 fait partie d'un assemblage 60 telles qu'illustrées en figures 11 et 12. Un exemple d'assemblage 60 dit « assemblage 3D » est encadré par des pointillés. Un transistor 10 au sein de cet assemblage est entouré par un cercle en trait plein. Ces assemblages 60 permettent de connecter facilement une pluralité de transistors 10, opérables indépendamment les uns des autres, pour former la matrice 70. En particulier, chaque assemblage 60 n'est connecté qu'à une seule ligne de mots WL.

## Revendications

1. Transistor (10) non-volatil comprenant :
- une couche semi-conductrice ferroélectrique (11) comprenant au moins un domaine ferroélectrique (12), le domaine ferroélectrique présentant une polarisation électrique spontanée (13) pouvant prendre une pluralité d'états distincts ;
- une première électrode conductrice (14), formant une « source » ;
- une deuxième électrode conductrice (15), formant une « grille » ; et
- une troisième électrode conductrice (16), formant un « drain »,
la source (14), la grille (15) et le drain (16) étant distants les uns des autres et agencés de sorte qu'un potentiel électrique appliqué entre la source (14) et la grille (15) applique un champ électrique sur le domaine ferroélectrique (12), le drain (16) étant en contact électrique avec la couche semi-conductrice ferroélectrique (11), la source (14) formant, avec la couche semi-conductrice ferroélectrique (11), une barrière Schottky (17) au niveau d'une interface entre la source (14) et la couche semi-conductrice ferroélectrique (11), la barrière Schottky (17) présentant une résistance électrique fonction de la polarisation électrique (13), le transistor étant **caractérisé en ce que** :
- la couche semi-conductrice ferroélectrique (11) est dégénérée au moins au niveau de l'interface entre la source (14) et la couche semi-conductrice ferroélectrique (11) ; et **en ce que**
- la couche semi-conductrice ferroélectrique (11) présente une conductivité électrique indépendante de la polarisation électrique spontanée (13).

2. Transistor (10) selon la revendication 1, dans lequel la grille (15) est électriquement isolée de la couche semi-conductrice ferroélectrique (11).

3. Transistor (10) selon l'une des revendications 1 ou 2, dans lequel la couche semi-conductrice ferroélectrique (11) comprend une première sous-couche semi-conductrice ferroélectrique (21) et une deuxième sous-couche ferroélectrique (22), la source (14) formant la barrière Schottky (17) avec la première sous-couche semi-conductrice ferroélectrique (21), la deuxième sous-couche ferroélectrique (22) étant disposée entre la première sous-couche semi-conductrice ferroélectrique (21) et la grille (15), la deuxième sous-couche ferroélectrique (22) présentant une conductivité électrique inférieure à la première sous-couche semi-conductrice ferroélectrique (21).

4. Transistor (10) selon l'une des revendications 1 à 3, dans lequel la grille (15) et le drain (16) sont agencés de sorte qu'un potentiel électrique appliqué entre la grille (15) et le drain (16) applique un champ électrique sur le domaine ferroélectrique (12).

5. Transistor (10) selon l'une des revendications 1 à 4, dans lequel le drain (16) forme, avec la couche semi-conductrice ferroélectrique (11), une barrière Schottky supplémentaire (30), au niveau d'une interface entre le drain (16) et la couche semi-conductrice ferroélectrique (11), la couche semi-conductrice ferroélectrique (11) étant également dégénérée au moins au niveau de l'interface entre le drain (16) et la couche semi-conductrice ferroélectrique (11), la barrière Schottky supplémentaire (30) présentant une résistance électrique fonction de la polarisation électrique (13).

6. Transistor (10) selon l'une des revendications 1 à 3, dans lequel la couche semi-conductrice ferroélectrique (11) comprend un domaine ferroélectrique supplémentaire (41), présentant une polarisation électrique spontanée (42) pouvant prendre une pluralité d'états distincts, le drain (16) formant, avec la couche semi-conductrice ferroélectrique (11), une barrière Schottky supplémentaire (30), au niveau d'une interface entre le drain (16) et la couche semi-conductrice ferroélectrique (11), la couche semi-conductrice ferroélectrique (11) étant également dégénérée au moins au niveau de l'interface entre le drain (16) et la couche semi-conductrice ferroélectrique (11), la barrière Schottky supplémentaire (30) présentant une résistance électrique fonction de la polarisation électrique (42) du domaine ferroélectrique supplémentaire (41).

7. Transistor (10) selon la revendication 6, dans lequel le drain (16) et la grille (15) sont agencés de sorte qu'un potentiel électrique appliqué entre le drain (16) et la grille (15) applique un champ électrique sur le domaine ferroélectrique supplémentaire (41).

8. Transistor (10) selon l'une des revendications 6 à 7, comprenant un espaceur (43) conducteur et non-ferroélectrique, la couche ferroélectrique (11) étant séparée en deux portions distincts par l'espaceur (43), l'espaceur (43) formant un contact ohmique avec chacune des deux portions de la couche ferroélectriques (11), l'une des portions de la couche ferroélectrique (11) comprenant le domaine ferroélectrique (12) et l'autre portion de la couche ferroélectrique (11) comprenant le domaine ferroélectrique supplémentaire (41).

9. Transistor (10) selon l'une des revendications 6 à 8, dans lequel la grille (15) comprend une première portion (15a) et une deuxième portion (15b), la première portion de grille (15a) étant agencée de sorte qu'un potentiel électrique appliqué entre la source (14) et la première portion de grille (15a) applique un champ électrique sur le domaine ferroélectrique (12), la deuxième portion de grille (15b) étant agencée de sorte qu'un potentiel électrique appliqué entre le drain (16) et la deuxième portion de grille (15b) applique un champ électrique sur le domaine ferroélectrique supplémentaire (41).

10. Assemblage (60) de transistors non-volatils comprenant une pluralité de transistors non-volatils (10) selon l'une des revendications 1 à 5 pour lesquels les couches semi-conductrices ferroélectriques (11) sont communes et forment une seule et même couche semi-conductrice ferroélectrique et pour lesquels les drains (16) sont communs et forment un seul et même drain commun, à chaque transistor non-volatil (10) correspond au moins un domaine ferroélectrique (12), le domaine ferroélectrique présentant une polarisation électrique spontanée (13) pouvant prendre une pluralité d'états distincts.

11. Assemblage (60) selon la revendication 10, dans lequel les sources (16) sont électriquement connectées les unes aux autres, voire les sources (16) sont communes et forment une seule et même source, et dans lequel les grilles (15) sont distinctes.

12. Assemblage (60) selon la revendication 10, dans lequel les grilles (15) sont communes et forment une seule et même grille et dans lequel les sources (16) sont distinctes.

13. Assemblage (60) selon l'une des revendications 10 à 12, comprenant un nanofil (71) et un nanotube (72) entourant le nanofil, le nanotube formant la couche semi-conductrice ferroélectrique (11) des transistors (10), le nanofil formant les grilles (15) des transistors, le drain (16) commun étant en contact électrique avec le nanotube (71).

14. Matrice (70) de transistors non-volatils comprenant :
- une première pluralité de lignes conductrices (SL), dites « lignes de source » ;
- une deuxième pluralité de lignes conductrices (WL), dites « lignes de mots » ;
- une troisième pluralité de lignes conductrices (BL), dites « lignes de données » ; et
- une pluralité de transistors (10) non-volatils selon l'une des revendications 1 à 5,
la source (14) de chaque transistor étant connectée à l'une des lignes de source (SL), la grille (15) de chaque transistor étant connectée à l'une des lignes de mots (WL) et le drain (16) de chaque transistor étant connectée à l'une des lignes de données (BL).

15. Matrice (70) selon la revendication 14, comprenant au moins un assemblage (60) de transistors non-volatils selon l'une des revendications 10 à 13, les transistors (10) de la matrice (70) connectés à une même ligne de mots (WL) appartenant au dit au moins un assemblage (60).
